(19) Europäisches Patentamt
European Patent Office
Office européen des brevets

(11) Publication number: **0 216 246 A1**

(12) **EUROPEAN PATENT APPLICATION**

(21) Application number: 86112483.2

(22) Date of filing: 09.09.86

(51) Int.Cl.[4]: H 01 L 27/10
H 01 L 29/92, H 01 L 21/82
G 11 C 17/00

(30) Priority: 09.09.85 JP 198760/85

(43) Date of publication of application:
01.04.87 Bulletin 87/14

(84) Designated Contracting States:
DE FR GB

(71) Applicant: FUJITSU LIMITED
1015, Kamikodanaka Nakahara-ku
Kawasaki-shi Kanagawa 211(JP)

(72) Inventor: Fukushima, Toshitaka
1604-442, Shiomidai Isogo-ku
Yokohama-shi Kanagawa, 235(JP)

(74) Representative: Schmidt-Evers, Jürgen, Dipl.-Ing. et al,
Patentanwälte Dipl.-Ing. H. Mitscherlich Dipl.-Ing. K. Gunschmann Dipl.-Ing. Dr.rer.nat. W. Körber Dipl.-Ing. J. Schmidt-Evers Dipl.-Ing. W. Melzer Postfach 26 01 32
D-8000 München 26(DE)

(54) **Semiconductor programmable memory device.**

(57) A field programmable device such as PROM of which memory cell is composed of a series connection of capacitor (C) and diode (D) or FET (Q). The programming is done by forming a short circuit in an insulation film (34) of the capacitor (C) by electrical breakdown of the capacitor (C). The capacitor (C) is composed of first and second semiconductor layer (10a) and an insulation film (34) between them. By taking such semiconductor insulator semiconductor structure of the capacitor (C), the instability of the short circuits by its further oxidation is avoided. So the memory stored in the device have been stabilized, and the reliability have been increased. The insulation film (34) of the capacitor (C) is oxidized or nitrided by ion implantation of oxygen or nitrogen into the semiconductor substrate (10), or polycrystalline material.

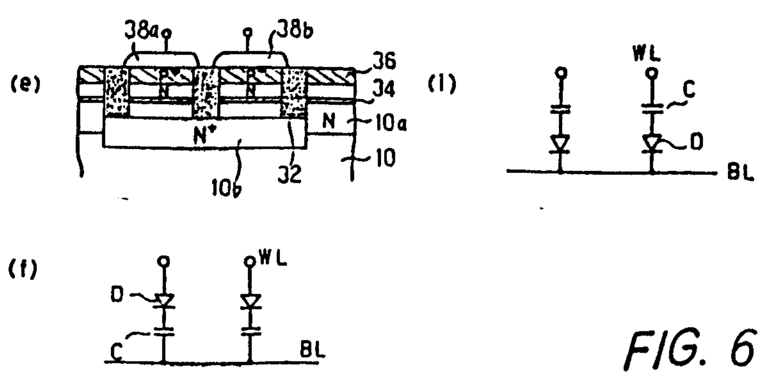


FIG. 6

EP 0 216 246 A1

Croydon Printing Company Ltd.

## TITLE OF THE INVENTION

SEMICONDUCTOR PROGRAMMABLE MEMORY DEVICE

## BACKGROUND OF THE INVENTION

The present invention is related to a semiconductor programmable device, and more specifically to a field programmable ROM (read only memory) or logic device.

There are several kinds of memory cells used for the programmable read only memory (PROM) devices, such as fuse type, diode type and so on. For example, Japanese Patent 52-40540 (1977) by T. Wada et al. discloses a capacitor and diode type memory cell, which basically discriminates its written or unwritten state by shorted or isolated state of a thin dielectric film.

Fig. 1(a) shows a cross sectional structure of the capacitor and diode type memory cell. In the figure, 10 is a semiconductor substrate, 12 is a diffusion region, 14 is a dielectric layer, 16 is an electrode formed on it, 18 is contact region for the substrate and 20 is an electrode to contact to it. The electrode 16, the dielectric layer 14 and the diffusion region 12 form a capacitor, and a diode is formed by the diffusion region 12 and the substrate 10. The equivalent circuit of such memory cell, therefore, becomes as shown in Fig. 1(b).

If a positive high voltage is applied to the electrode 20, and a negative high voltage is applied to the electrode 16, the dielectric layer beneath the electrode 16 is electrically broken down, and the memory cell becomes a written state. So long as such voltage is not applied, the memory cell keeps the state of Fig. 1(b), corresponding to an unwritten state. These written and unwritten states are corresponded to data of "1" and "0", and hence it functions as a programmable memory cell.

Fig. 2 is an example of a fuse and diode type memory cell disclosed in Japanese Patent 53-26462 (Priority in U.S. 1971, Ser. No 181503) by S. A. Appas et al. In Fig. 2(a), which shows a cross sectional structure of a memory cell, 10 is an n-type semiconductor substrate, 12a and 12b are a p-type and $n^+$-type diffusion layers respectively, 14 is an insulation layer and 22, 24 are layers of conductor. The thickness of the insulation layer 14 over the diffusion layer 12b is controlled to be thin. If a high voltage having a polarity to flow a current in a diode composed by the diffusion layers 12a and 12b, the metal of conductor layer 22 diffuses through the thinned portion of the insulator layer 14, and forms a conductive filament 22a. So, an equivalent circuit of the memory cell of Fig. 2(a) becomes as shown in Fig. 2(b). The conductive filament 22a becomes a fuse element, the conductor layer 24 becomes a word line, and the diffusion layer 12a becomes the bit line of the memory cell. The programming (writing) in the memory cell is done by applying a high voltage between the word line and bit line in a direction to run a high current in the conductive filament to burn it out.

Fig. 3 shows a capacitor and diode type memory matrix disclosed in Japanese laid open Patent 53-132281 (1978) by K. Okada. Fig. 3(a) shows its cross sectional view, in the figure, 10 is a p-type semiconductor substrate, 10a is an n-type epitaxial layer, 10b is an $n^+$-type buried layer, 10c is a $p^+$-type isolation layer, 12 is a $p^+$-type diffusion layer, 14a is an isolation layer and 16 is an electrode. In this configuration, the electrode 16, the isolation film 14a and the $p^+$-type diffusion layer 12 compose the capacitor, and the diffusion layer 12 and the n-type epitaxial layer 10a compose the diode. The capacitor and the diode compose a memory cell similar to that of Fig. 1. Fig. 3(b) shows a memory matrix composed of such memory cells. The writing (programming) of the memory is done, by applying a voltage between a bit line and a word line in a direction to flow a current in the diode, and burning out the insulation film 14a of the capacitor.

As have been described above, the capacitor and diode type PROM is programmed by short circuiting the insulation film of the capacitor, and the short circuit or not is corresponded to "1" or "0" of the data. The reliability of the memory, therefore, depends on the stability of the broken down insulation films. Fig. 4 is an enlarged cross sectional view of an electrically broken down part of the insulation film. In the figure, 14 is the insulation layer (usually it is a silicon dioxide layer), 26 and 28 are the electrodes. When a voltage V is applied between the electrodes, current I does not flow unless the voltage exceeds the breakdown voltage, and the resistance between the electrodes is substantially infinity.

But when a dielectric breakdown occurs, a large current I flows. Fig. 4 shows a state after a breakdown had occurred. The insulation layer 14 is bridged by a diffused region 14b of the electrode material, and surround it an oxidized region 14c is formed, and the electrodes 26 and 28 are short circuited to each other. The oxidized region 14c is formed by an oxidation of the electrode metal by oxygen supplied from the insulation layer (usually it is an oxide layer). In such device, when the ambient temperature is increased, the oxidized region grows further and it eats away little by little the diffused region 14b of the electrode material, and the resistance between the electrodes 26 and 28 increases gradually, and at last the electrodes are disconnected from each other, that is equivalent to the unwritten state.

Fig. 5 shows the variation of V-I characteristics of a memory cell. Namely, when the memory cell is programmed, or written, the resistance between the electrodes are small, and so the V-I curve of the memory cell is stiff as shown by a full line. But, as time passes, the slope of the V-I curve shifts to the direction of arrow and gradually becomes gentle as shown by broken lines. This means the increase of the resistance of the memory cell or the decrease of the read out current and operation speed of the memory cell.

Such defect may be avoided by selecting the material of the electrode which is not be oxidized for an oxide insulation layer, or not be nitrided for a nitride insulation layer. But in the present-state-of-the-art the material applicable to the electrode is limited to a small kinds of material such as tungsten or molybdenum. The material is limited by the condition of fabrication process of the semiconductor devices, such that it must withstand a temperature applied during the fabrication, it must have a good affinity to the insulation layer or to a wire bonding, and its patterning must be easy and so on.

Considering the affinity to the oxide insulation layer for example, the electrode material must have a low free energy against the oxidation. This means the material diffused into the insulation layer is easy to be oxidized, and the resistance of the diffused region is apt to vary its value, and hence, the reliability of the memory is not so high.

SUMMARY OF THE INVENTION

The object of the present invention, therefore, is to improve the above defects and provide a semiconductor programmable device, such as programmable ROM or programmable logic device having a high reliability and easy to fabricate.

Another object of the present invention is to provide a programmable device having a wide freedom in its design and fabrication process.

The present invention avoids the problem caused by the oxidation of the electrode material by replacing the electrode material with a semiconductor material, and hence replacing the fundamental configuration of metal insulator semiconductor structure to semiconductor insulator semiconductor structure. The insulation layer is fabricated by implantation of oxygen or nitrogen into the layer of semiconductor. For example, a silicon oxide layer is formed in silicon layer by oxygen ion implantation.

By doing so, both sides of the insulation layer are filled with semiconductor, and the short circuit bridging the insulation layer to "write" the memory is composed from diffused layer of semiconductor material into the oxide layer of itself. Since the free energy of the semiconductor material against the oxide is higher than that of metal, the problem of the oxidation of the short circuit, and hence the increase of the resistance of the short circuit is avoided.

Such technology is applicable also to various types of field programmable logic devices.

The invention proposes various structures of the semiconductor oxide semiconductor memory cell, which can be fabricated in various way of process. So, it extends the freedom of design and fabrication of the programmable memory device. These and other advantages of the invention will be apparent from the following description of preferred embodiments taken in connection with the accompanying drawings.

## BRIEF DESCRIPTION OF THE DRAWINGS

Fig. 1 shows a fundamental configuration of prior art capacitor and diode type memory cell of a programmable memory device, wherein:

Fig. 1(a) is a schematic cross sectional view of the memory cell; and,

Fig. 1(b) is its equivalent circuit diagram.

Fig. 2 shows a fundamental configuration of prior art fuse and diode type memory cell of PROM, wherein:

Fig. 2(a) is a schematic cross sectional view of the memory cell; and

Fig. 2(b) is its equivalent circuit diagram.

Fig. 3 shows a general configuration of prior art PROM device, wherein:

Fig. 3(a) is a schematic cross sectional view of the memory cell; and

Fig. 3(b) is its equivalent circuit diagram.

Fig. 4 shows schematically an enlarged cross section of a potion of electrically broken down insulation layer.

Fig. 5 shows a variation of V-I characteristics of a memory cell caused by oxidation of the short circuit composed in the insulation layer of a memory cell.

Fig. 6 shows schematic cross sections of memory cells for first embodiment of the present invention illustrating steps of their fabrication process.

Fig. 7 shows schematically cross sections of memory cells for second embodiment of the present invention illustrating steps of their fabrication process.

Fig. 8 illustrates application of the present invention to fabricate various types of lateral memory cell.

Fig. 9 shows an example of capacitor and FET (field effect transistor) type memory cell, wherein:

Fig. 9(a) is a schematic cross section of the memory cell;

Fig. 9(b) shows a device of Fig. 9(a) protected its surface by a passivation film; and

Fig. 9(c) is its equivalent circuit diagram.

Throughout the drawings, similar or like reference numerals designate same or similar parts.

## DESCRIPTION OF THE PREFERRED EMBODIMENTS

The structure and process to fabricate the memory device by the present invention will be described with respect to following embodiments.

### First Embodiment

Fig. 6 are cross sections of memory devices illustrating steps of their fabrication processes. Fig. 6(a) shows a structure of the semiconductor substrate. In the figure, 10 is a p-type semiconductor substrate having a resistivity of 0.5 Ohms doped with boron for example. 10a is a phosphorus doped n-type epitaxial layer having a resistivity of 0.5 Ohms, and approximately 3 μm thick grown over the substrate 10. 10b is an $n^+$-type buried layer doped with antimony for example.

As shown in Fig. 6(b), isolation regions 32 of approximately 2 μm wide are formed in the epitaxial layer 10a. The spacing between the isolation regions 32 is approximately 3 μm. Formation of such isolation regions 32 are done, for example, by ion implantation of oxygen with an energy of 150 keV. and dose of $10^8$ $cm^{-2}$. The formation of the isolation regions 32 is not limited in the ion implantation but it may be fabricated by various technology, for example, the technology of oxide surrounded transistor (OST) or shallow V-groove (SVG) technology are applicable. The SVG technology make grooves in the epitaxial layer and fill up the grooves with silicon dioxide. The method to fabricate such separation region is not explicitly related to the present invention, so, further description is omitted. More detail of such technology is disclosed for example in "An Advanced SVG Technology for 64K Junction Shorting PROM's" by T. Fukushima et al. IEEE Trans. ED-30, No. 12, Dec. 1983.

Next, as shown in Fig. 6(c), a thin layer 34 of silicon dioxide having a thickness from a few tens to hundreds of A° is formed in the epitaxial layer 10a at a depth of approximately 1.3-1.4 μm from its surface, by implanting oxygen with an energy of 70 keV, and $10^8$ $cm^{-2}$ dose for example. Further detail of fabrication of oxide layer in the silicon substrate is disclosed for example in "High Speed C-MOS IC Using Buried $SiO_2$ Layer Formed by Ion Implantation" by K. Izumi et al, Jap. Jour. Appl. Phys., vol. 19, Supp. 19-1, PP.151-154, 1980, and in "Surface Silicon Crystallinity and Anomalous Composition Profiles of Buried $SiO_2$ and $Si_3N_4$ Layers Fabricated by Oxygen and Nitrogen Implantation in Silicon" by S. Maeyama et al, Jpn. Jour. Appl. Phys. vol, 21, No. 5, May, 1982 PP. 744-751.

Succeedingly, as shown in Fig. 6(d) the surface of the epitaxial layer 10a is doped with boron of $10^4$ R dose to a depth of 0.7 μm and formed a $p^+$-type layer 36 of 0.7 μm thick. The $p^+$-type layer 36 may be fabricated by any process such as diffusion or ion implantation etc. After the doping, the substrate is annealed at proper temperature, but they are common process in the art, so further description is omitted.

Then the electrodes 38a and 38b are formed as shown in Fig. 6(e), and the memory cells as shown by an equivalent circuit of Fig. 6(f) is completed. The diodes D are composed by the $p^+$-type layer 36 and the n-type epitaxial layer, and the capacitor C is composed of the insulation layer 34 sandwiched by the epitaxial layer 10a. The material for the electrode may be of any kind such as aluminum, various silicide or polysilicon. Surface passivation may be done by conventional method, so further description of such process are omitted. It will be obvious for the one skilled in the art that in Figs. 6 (e) and (f), the diodes D can be replaced by Shottky diodes which are fabricated by the epitaxial layer 10a and the metal electrodes 38a and 38b.

A modification of above process may be possible, for example, succeeding to the step (b), as shown in Fig. 6(g), $p^+$-type layer 40 of 1.3-1.4 μm is formed by doping boron with a dose of $10^4$ $cm^{-2}$ for example, then as shown in Fig. 6(h), the insulation layer 34 is formed in the doped layer of 40 like a similar manner of the step (c). Then forming the electrode like a manner of the step (e), the memory cells as shown by and equivalent circuit of Fig. 6(i) is obtained. In this embodiment, the position of the capacitor and the diode is reversed to that of Fig. 6(f).

The programming of the memory cell is done by applying a voltage between the word line WL and the bit line BL in a direction to run a current in the diode D. The short circuit of the capacitor is formed by a diffusion of high doped semiconductor material (it is a silicon in the above embodiment) into the insulation layer 34. The free energy to form a silicon oxide is high, so the problem of further oxidation of the short circuit is avoided. So, the operation of the memory cell is stabilized. Silicon may be also oxidized at high temperature near to its melting point. But the semiconductor device is never used in such high temperature, so, the high reliability of the memory cell is attained. Moreover, the affinity of the silicon to the oxide layer is good, so the the problem of the contact is also avoided.

Second Embodiment

Fig. 7 illustrates the steps of a fabrication process for second embodiment of the present invention. The process starts with a p-type semiconductor substrate 10 similar to that of the first embodiment. The n-type epitaxial layer 10a, $n^+$-type buried layer 10b, and the isolation regions 32 are formed. They are all same to those of Fig. 6. and the steps (a) and (b) are also similar to those of Fig. 6. So, repetition of the description is avoided.

As shown in Fig. 7(c), a $p^+$-type layer 36 of approximately 1.3-1.4 μm thick is formed by the similar manner of the step (g) in Fig. 6. Then, the isolation regions 32 are further extended their height about 1 μm by selectively growing the silicon dioxide layers 32a on the isolation region 32 as shown in Fig. 6(g). Such additional growth is done by any of conventional methods such as a chemical vapor deposition (CVD) and photolithographic etching.

Next, as shown in Fig. 7(d), the surface of the $p^+$-type layer 36 is covered by a film of silicon dioxide 42 having a thickness of an order from few tens to hundreds of A°. This film is formed by any of conventional process, such as thermal oxidation, or CVD. After that, on the surface of the silicon dioxide layer 42 is formed a highly boron doped $p^+$-type polysilicon layer 44 of approximately 0.7 μm thick is formed as shown in Fig. 7(e).

Then by forming the electrodes 38a and 38b as shown in Fig. 7(f), the memory cells as shown by an equivalent circuit of Fig. 7(g) is completed. The surface passivation, the formation and wiring of the electrodes are similar to conventional semiconductor devices. In this memory cell, the capacitor C is composed of the poly silicon layer 44, the silicon dioxide layer 42 and the $p^+$-type epitaxial layer 36. And the diode D is composed of the $p^+$-type layer 36 and the n-type epitaxial layer 10a.

In this embodiment, after the step (e) of the fabrication process, the polysilicon layer 44 may be recrystallized by laser irradiation or electron beam irradiation. By doing so, the resistance of the memory cell is further decreased, and a better characteristics of the memory operation is expected. The process to recrystallize the polysilicon is disclosed for example in U.S. Patent 4,575,925 (Mar. 18, 1986) by K. Kanbara et al.

Third Embodiment

The structure of the memory cells as described with respect to the first and second embodiments may be called as vertical type, because the diode and capacitor are arranged vertically in the substrate. But it is possible to provide a lateral type memory cell, in which the diode and capacitor are arranged in lateral direction; that is parallel to the surface of the substrate.

Fig. 8 illustrates the fabrication steps of the lateral type memory cell. As shown in Fig. 8(a), on an $n^+$-type silicon epitaxial layer 10 is formed a silicon dioxide layer 42 of approximately 5,000 A° thick. The epitaxial layer 10 of the Fig. 8(a) corresponds to the epitaxial layer 10a of Fig. 6(a). The silicon dioxide layer 42 may be fabricated by any conventional method, such as CVD or thermal oxidation, for example.

Next, as shown in Fig. 8(b), a polysilicon layer 44 of approximately 1 μm thick is formed. Then the polysilicon layer 44 is isolated by silicon dioxide isolation regions 48 and 46 as shown in Fig. 8(c). The width of the isolation region 48 is approximately 2 μm, and the width of the isolation region 46 is from few tens to hundreds of A°. This process is similar to that of the process (b) in Fig. 6. The isolation region 46 becomes an isolation film of the capacitor. The isolation region 48 may be formed by the oxygen ion implantation, FIOS, OST or SVG method. As a modification, the isolation region 48 may be etched off as shown in Fig. 8(d). Then the isolation region 46 is formed as shown in Fig. 8(e).

Following to the isolation process, the diode and capacitor are formed by doping the polysilicon layer 44. In this step, various modifications of the configurations are possible as shown in Fig. 8(f) through (i).

In the configuration of Fig. 8(f), the polysilicon layer 44 is divided into four sections 44a, 44b, 44c and 44d, each having a width of approximately 1 μm. The sections 44a and 44b are left undoped, and the sections 44c and 44d are doped and transferred to p and n type regions respectively. The capacitor is composed of the isolation region 46 and the polysilicon sections 44a and 44b. The diode is composed of the sections 44c and 44d.

In the configuration of Fig. 8(g), the polysilicon layer 44 is divided into three sections 44a, 44b, and 44c. The width of the section 44b is approximately 2 μm, and the width of the other sections are approximately 1 μm. The sections 44a and 44b are doped with a p-type dopant and the section 44c is doped with n-type dopant. The capacitor is composed of the isolation region 46 and the polysilicon sections 44a and 44b. The diode is composed of the sections 44b and 44c.

In the configurations of Fig. 8(h) and (i), the position of the isolation region 46 is different to those of Fig. 8(f) and (g). So the position of the diode and capacitor is reversed to each other, but other parts are all similar. Of course it is possible to alter the position of the p and n type doped sections to reverse the direction of conductivity of the diode.

The doping is done by conventional selective diffusion using photolithography. Of course, it may be done by ion implantation. For the p and n type dopant for example, boron and phosphorus are used respectively. After the memory cells are formed like such manner, the surface of the device is coated with a passivation film as shown in Figs. 8(j) and (k). Usually the passivation film is silicon dioxide, or phospho-silicate glass. The electrodes are contacted to respective points through an opening provided in the passivation film. It is also possible to take the contact from the side of the semiconductor substrate 10. These are all conventional in the art, so further description is omitted.

Fourth Embodiment

The diodes in the memory cell are used to block the reverse current flow through the unselected memory cells when the memory matrix is in read out or program operation. Namely, in the read out operation for example, the bit line and the word line corresponding the memory cell to be read out are positively and negatively biased respectively, and the remaining bit lines are negatively and the word lines are positively biased. Therefore, without the blocking diodes, the unselected memory cells flow currents and the read out operation can not be performed. But if the diodes are provided, the diodes of the unselected memory cells are reversely biased, and the reverse currents are blocked. So, only the selected memory cell flows the current and the read out process is performed.

Such blocking of the reverse currents can be done not only by diode but by other devices such as FETs (field effect transistors). Fig. 9 shows schematically a cross section of an embodiment using a MOS (metal oxide semiconductor) transistor in the place of the diode. In Fig.

9(a), 50 and 52 are respectively the source and drain region, 54 and 56 are the source and drain electrodes respectively. 60 is a gate electrode, and these altogether compose the MOS transistor Q. The electrodes 54, and 56 are extended over a field oxide layer 42 and wired properly.

For the gate electrode of the MOS transistor is often used polycrystalline silicon. In this embodiment, the source and drain electrodes are also formed by the polysilicon. In the source electrode 56 is formed a thin insulation layer 46 of silicon dioxide as shown in Fig. 9(a). The thickness of the insulation layer 46 is from few tens to hundreds of A°, and its formation process is similar to that of the layer 46 in the third embodiment. As shown in Fig. 9(b), the surface of the device is coated with a surface passivation layer 62 of a silicon dioxide film, for example. And Fig. 9(c) shows an equivalent circuit of a memory cell. In this memory cell, the capacitor C is composed of the both parts 56, 58 of the drain region 56 seperated by the thin insulation layer 46.

In the above description, the embodiments have been disclosed with respect to silicon substrate and the insulation layer of silicon dioxide. But it will be clear for the one in the art that, the insulation layer may be silicon nitride for example, in such case nitrogen implantation is applicable, further the silicon may be replaced by any kind of semiconductor material such as germanium or gallium arsenide.

As have been described above, the present invention has changed the structure of the capacitor of the PROM device from a metal-oxide-semiconductor structure to a semiconductor-oxide-semiconductor structure. So, the variation of the resistance of the short circuit during its operation has been avoided, and a stable memory operation has been attained.

Above disclosure of the present invention have been provided with respect to the memory devices, but it will be also clear for the one skilled in the art that the memory cells described above are applicable to a logic circuit to provide a filed programmable logic device.

## CLAIMS

1. A semiconductor programmable device having a memory cell composed of a series connected capacitor (C) and a reverse current blocking device (D), said capacitor (C) being composed of a first semiconductor layer (40, 10a; 44; 44a, 44c; 56), an insulation film (34; 42; 46), and a second semiconductor layer (40, 10a; 36; 44b, 44d; 58) said memory cell being programmable by applying a high voltage to said capacitor (C) and forming a bypass circuit in said insulation film (34; 42; 46) of said capacitor (C) by dielectric breakdown of said insulation film (34; 42; 46).

2. A semiconductor programmable device according to claim 1, wherein said first and second semiconductor layers (40, 10a) being a part of a semiconductor substrate (10), and said insulation film (34) being formed between said first and second semiconductor layers (40, 10a).

3. A semiconductor programmable device according to claim 1, wherein said first semiconductor layer (44) being a polycrystalline semiconductor, said insulation film (42) being an oxide film, and said second semiconductor layer (36) being a part of said semiconductor substrate (10).

4. A semiconductor programmable device according to claim 1, wherein said first semiconductor layer (44) being a single crystal layer which is recrystallized from a polycrystalline semiconductor, said insulation film 42) being an oxide film, and said second semiconductor layer (36) being a part of said semiconductor substrate (10).

5. A semiconductor programmable device according to claim 1, wherein said first and second semiconductor layers being single crystal layer which is recrystallized from a polycrystalline semiconductor, and said insulation film being an oxide film.

6. A semiconductor programmable device according to claim 1, wherein said first and second semiconductor layers (40, 10a; 44 and 40, 10a; 36) being arranged vertically on said semiconductor substrate (10).

7. A semiconductor programmable device according to claim 1, wherein said that first and second semiconductor layers (44a, 44c; 56 and 44b, 44a; 58) being arranged laterally on said semiconductor substrate (10).

8. A semiconductor programmable device according to claims from 1 through 7, wherein said semiconductor (10) being silicon and said insulation film (34; 42; 46) being a silicon dioxide film.

9. A semiconductor programmable device according to claims form 1 through 7, wherein said semiconductor (10) being silicon and said insulation film being a silicon nitride film.

# FIG. 1

PRIOR ART

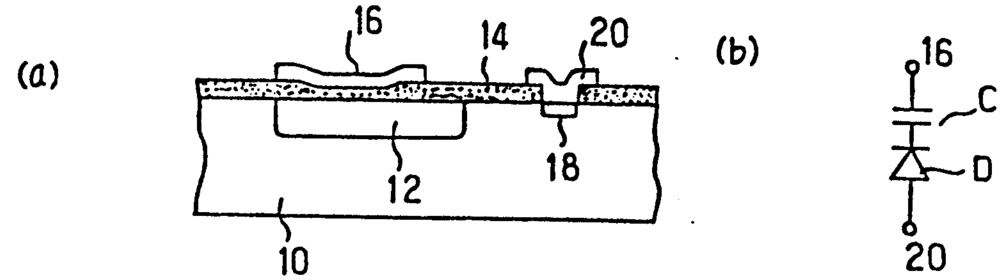


# FIG. 2

PRIOR ART

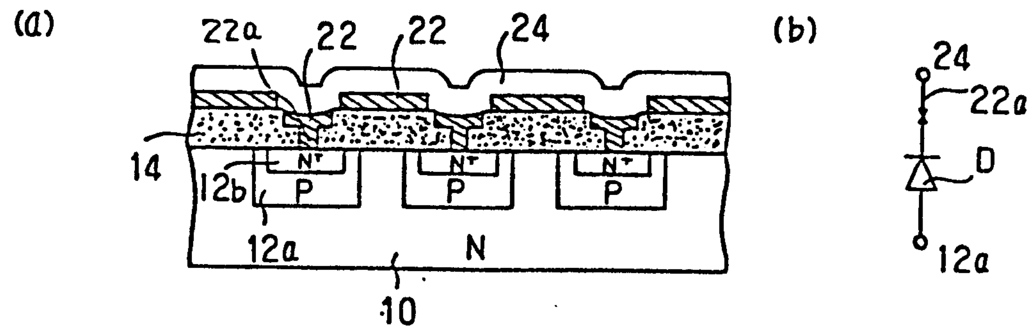


# FIG. 3

PRIOR ART

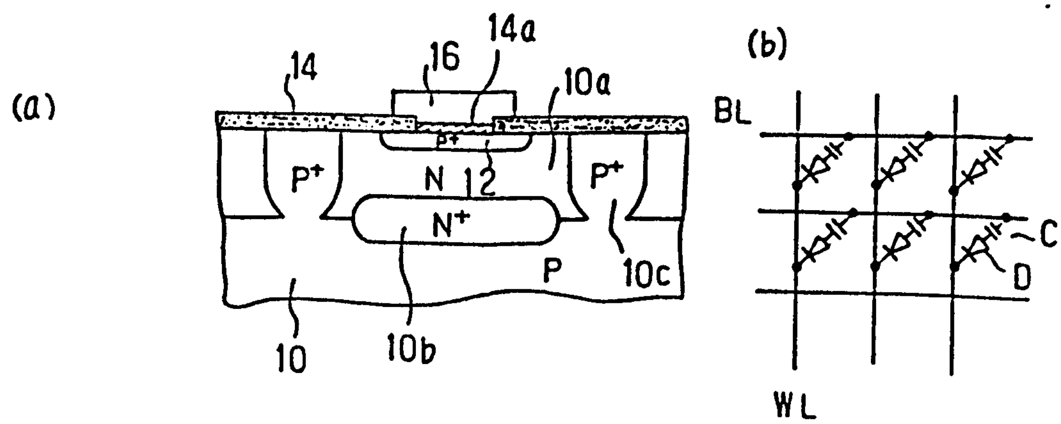

FIG. 4

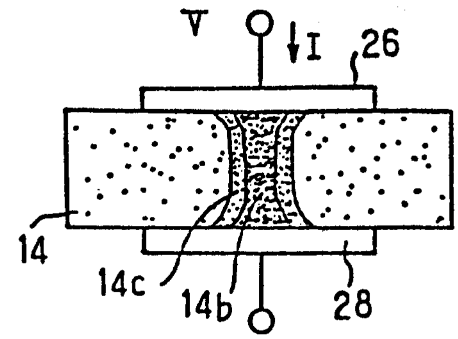


FIG. 5

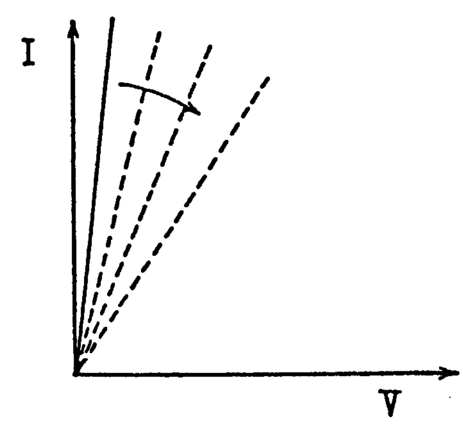

FIG. 6

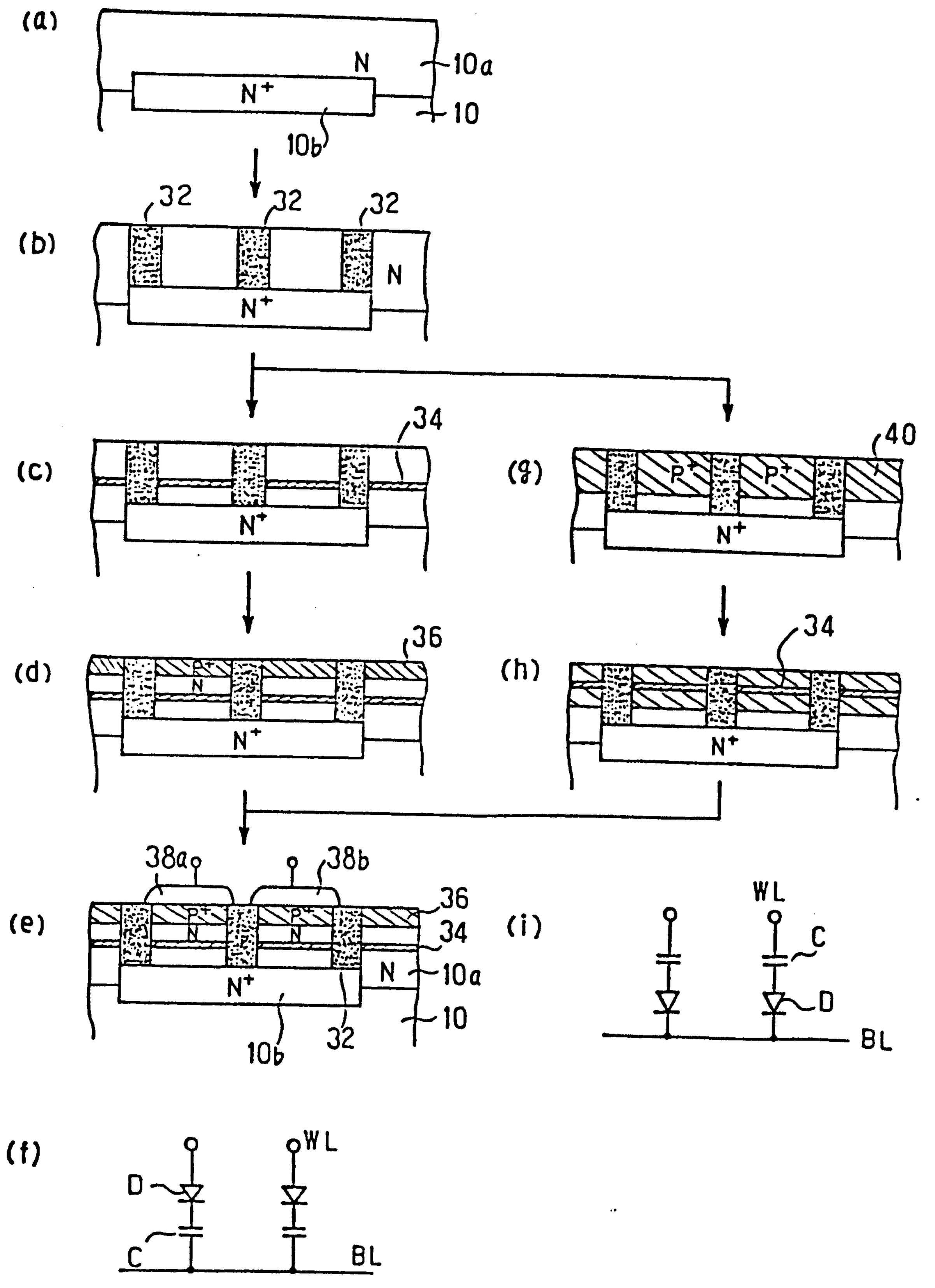
(a)
N
10a
N+
10
10b
(b)
32
32
32
N
N+
(c)
34
N+
(g)
40
P+
P+
N+
(d)
36
P+
N
N+
(h)
34
N+
(e)
38a
38b
36
P+
P+
N
N
34
N
10a
N+
10
10b
32
(i)
WL
C
D
BL
(f)
WL
D
C
BL

FIG. 7

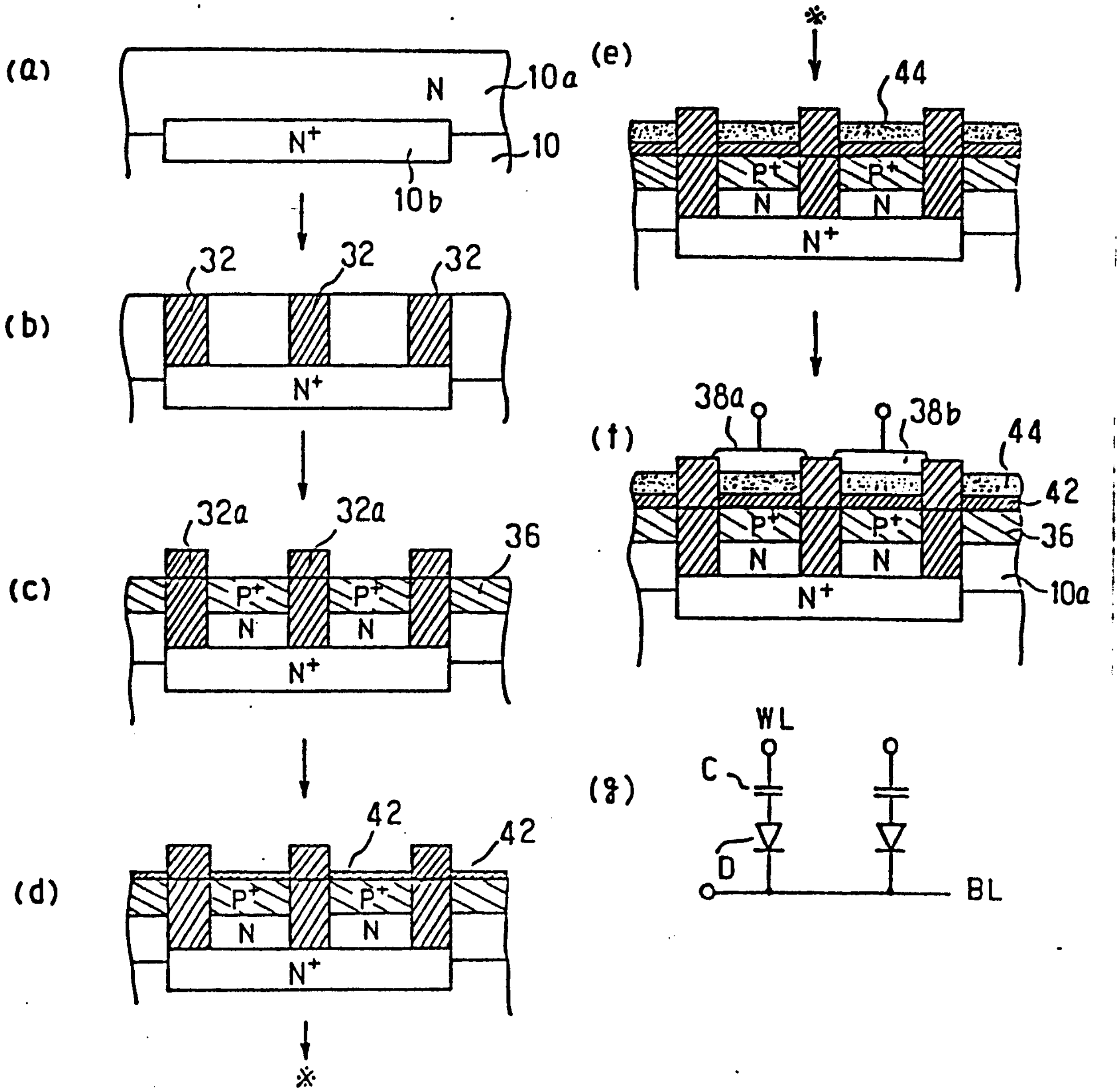
(a)
N
N+
10a
10
10b
(b)
32
32
32
N+
(c)
32a
32a
36
P+
P+
N
N
N+
(d)
42
42
P+
P+
N
N
N+
※
(e)
※
44
P+
P+
N
N
N+
(f)
38a
38b
44
42
36
10a
P+
P+
N
N
N+
(g)
WL
C
D
BL

FIG. 8

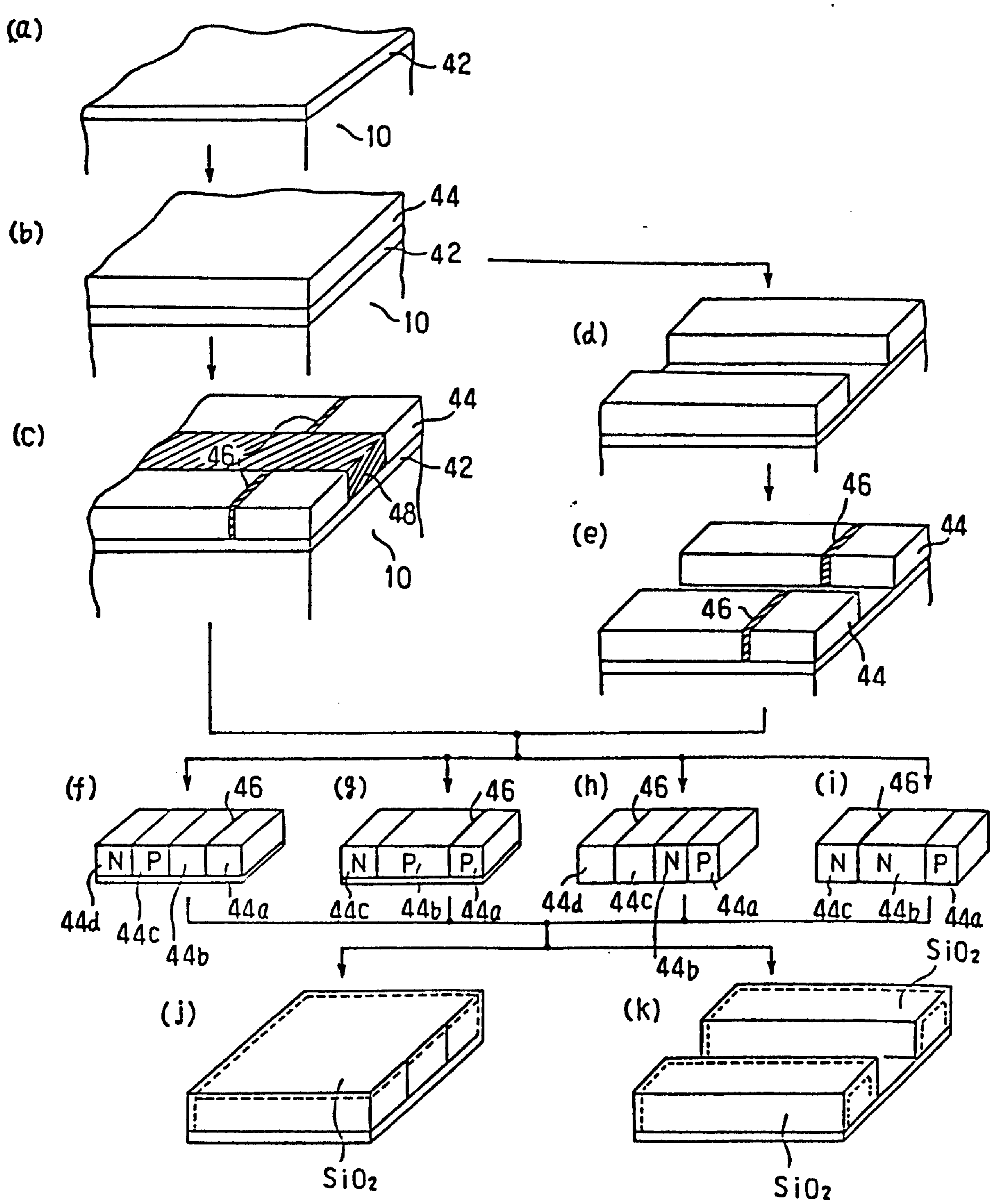

(a)
42
10
(b)
44
42
10
(c)
44
46
42
48
10
(d)
(e)
46
44
46
44
(f)
46
N
P
44d
44c
44b
44a
(g)
46
N
P
P
44c
44b
44a
(h)
46
N
P
44d
44c
44b
44a
(i)
46
N
N
P
44c
44b
44a
(j)
SiO2
(k)
SiO2
SiO2

FIG. 9

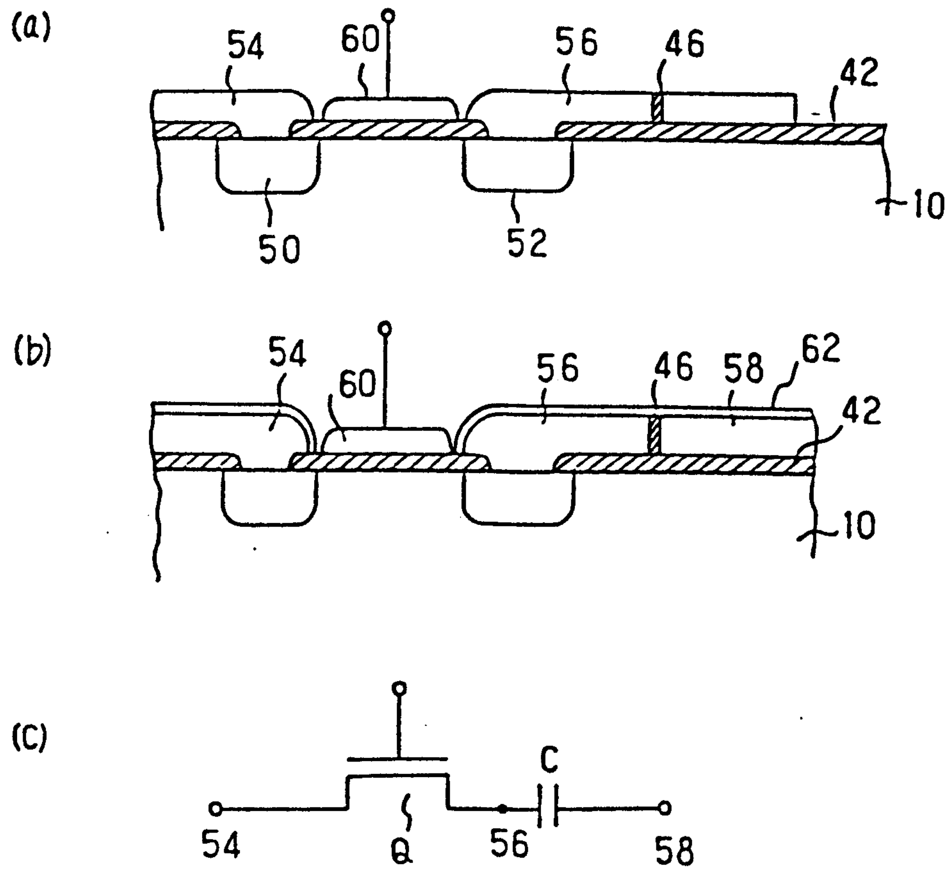

European Patent Office

# EUROPEAN SEARCH REPORT

0216246

Application number

EP 86 11 2483

## DOCUMENTS CONSIDERED TO BE RELEVANT

| Category | Citation of document with indication, where appropriate, of relevant passages | Relevant to claim | CLASSIFICATION OF THE APPLICATION (Int. Cl 4) |
|---|---|---|---|
| X | US-A-4 322 822 (R.K. McPHERSON) * Figures 2,3; column 2, lines 1-50 * --- | 1,3,8 | H 01 L 27/10<br>H 01 L 29/92<br>H 01 L 21/82<br>G 11 C 17/00 |
| A,D | JAPANESE JOURNAL OF APPLIED PHYSICS, vol. 21, no. 5, May 1982, pages 744-751, Tokyo, JP; S. MAEYAMA et al.: "Surface Silicon Crystallinity and Anomalous Composition Profiles of Buried SiO2 and Si3N4 Layers Fabricated by Oxygen and Nitrogen Implantation in Silicon" * Figures 2,5; page 749, left-hand column, line 3 - right-hand column, line 37 * --- | 2,8,9 | |
| | | | TECHNICAL FIELDS SEARCHED (Int. Cl.4) |
| A | ELECTRONIC DESIGN, vol. 32, no. 5, March 1983, page 50, Waseca, Denville, US; C. PANASUK: "Single-poly CMOS builds reliable, stable capacitors" * Whole document * --- -/- | 1,3,6,8 | H 01 L<br>G 11 C 17/00 |

The present search report has been drawn up for all claims

| Place of search | Date of completion of the search | Examiner |
|---|---|---|
| THE HAGUE | 08-12-1986 | MACHEK, J. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

European Patent Office

# EUROPEAN SEARCH REPORT

0216246

Application number

EP 86 11 2483

Page 2

| DOCUMENTS CONSIDERED TO BE RELEVANT | | | |
|---|---|---|---|
| Category | Citation of document with indication, where appropriate, of relevant passages | Relevant to claim | CLASSIFICATION OF THE APPLICATION (Int. Cl.4) |
| A | JOURNAL OF THE ELECTROCHEMICAL SOCIETY, vol. 132, no. 1, January 1985, pages 211-219, Manchester, New Hampshire, US; G.K. CELLER: "Dielectrically Isolated Thick Si Films by Lateral Epitaxy from the Melt" * Figure 14; page 211, first paragraph - page 212, line 4 * | 4,5,7 | |
| | ----- | | |
| | | | TECHNICAL FIELDS SEARCHED (Int. Cl.4) |

The present search report has been drawn up for all claims

| Place of search | Date of completion of the search | Examiner |
|---|---|---|
| THE HAGUE | 08-12-1986 | MACHEK, J. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document